# EUROPEAN PATENT SPECIFICATION

(11) **EP 1 548 853 B1**
(45) Date of publication and mention of the grant of the patent: **22.12.2010**
(21) Application number: 03753937.6
(22) Date of filing: 18.09.2003
(51) Int. Cl.: H01L 39/24

(54) **METHOD OF VARYING THE PLASMA FREQUENCY OF A HIGH-TEMPERATURE SUPERCONDUCTOR JOSEPHSON TUNNEL JUNCTION**
VERFAHRUNG ZUM VARIIEREN DER PLASMAFREQUENZ EINES JOSEPHSON-TUNNELÜBERGANGS MIT HOCHTEMPERATUR-SUPRALEITER
PROCEDE DE VARIATION DE LA FREQUENCE DE PLASMA D'UNE JONCTION TUNNEL JOSEPHSON EN SUPRACONDUCTEUR À HAUTE TEMPERATURE

(30) Priority: 20.09.2002 JP 2002275873
(43) Date of publication of application: 29.06.2005
(73) Proprietor: National Institute for Materials Science, Tsukuba-shi, Ibaraki 305-0047 (JP)
(72) Inventor: TAKANO, Yoshihiko, Tsukuba-shi, Ibaraki 305-0047 (JP); HATANO, Takeshi, Tsukuba-shi, Ibaraki 305-0047 (JP); KIM, Sangjae, Tsukuba-shi, Ibaraki 305-0047 (JP); ISHII, Akira, Tsukuba-shi, Ibaraki 305-0047 (JP); ARISAWA, Shunichi, Tsukuba-shi, Ibaraki 305-0047 (JP); TOGANO, Kazumasa, Tsukuba-shi, Ibaraki 305-0047 (JP); TACHIKI, Masashi, Tsukuba-shi, Ibaraki 305-0047 (JP); YAMASHITA, Tsutomu, Tsukuba-shi, Ibaraki 305-0047 (JP)
(74) Representative: Calamita, Roberto
(86) International application number: PCT/JP2003/011912
(87) International publication number: WO 2004/027885

(56) References cited:
- EP-A2- 1 182 712
- JP-A- 7 273 377
- US-A1- 2002 025 586
- HAMILTON CLARK A: "Josephson voltage standards" REVIEW OF SCIENTIFIC INSTRUMENTS, AMERICAN INSTITUTE OF PHYSICS, US, vol. 71, no. 10, October 2000 (2000-10), pages 3611-3623, XP012037733 ISSN: 0034-6748
- HIROYUKI SHIBATA: 'Do sankabutsu cho dendotai ni okeru josephson plasma kyomei no tsuka sokutei ni yoru kansoku' SOLID STATE PHYSICS vol. 34, no. 8, August 1999, pages 35 - 42 (691 - 698), XP002975836
- WANG H B ET AL: "Investigation of microwave responses in BSCCO-2212 intrinsic Josephson junctions up to short millimeter wavebands" PHYSICA C, NORTH-HOLLAND PUBLISHING, AMSTERDAM, NL LNKD- DOI:10.1016/S0921-4534(00)01472-6, vol. 341-348, 1 November 2000 (2000-11-01) , pages 2737-2738, XP004761889 ISSN: 0921-4534
- MATSUDA Y ET AL: "Vortex state of high-Tc superconductors studied by Josephson plasma resonance" PHYSICA C, NORTH-HOLLAND PUBLISHING, AMSTERDAM, NL LNKD- DOI:10.1016/S0921-4534(01)00648-7, vol. 362, no. 1-4, 1 September 2001 (2001-09-01), pages 64-70, XP004319526 ISSN: 0921-4534

## Description

The present invention relates to a method of controlling a property of a high temperature superconductive Josephson tunnel junction. More particularly, the invention relates to a method of varying the plasma frequency of a high temperature superconductive Josephson tunnel junction by varying the intersecting angle between two single crystals of a high temperature superconductor.

A Josephson tunnel junction device using a superconductor (SIS-JJ device) is a basic superconductive device and it has been applied as a high frequency device, an SFQ device (a switching device utilizing flux of line of magnetic force), a SQUID magnetic sensor device and others. Further enhancement of performance is expected if the Josephson tunnel junction device can be made of a high temperature superconductor.

The inventors of the present application have already proposed formation of a Josephson junction in or near a bond of whisker crystals by intersecting whisker crystals of a high temperature superconductor and by heat treatment as a means of solving a technical problem of easily and quickly forming a Josephson junction having excellent properties without requiring any expensive fine processing equipment (EP 1 182 712 A). This application specifically proposes that a Josephson junction is formed by disposing two whisker crystals of a bismuth 2212 high temperature superconductor in a cross on an MgO substrate and putting the MgO substrate in a furnace for heat treatment in a baking condition of temperature of 850 °C, oxygen partial pressure of 70% and baking time of 30 minutes.

The present invention is further advanced from the technology of the previous proposal and it is intended to provide a high temperature superconductive Josephson tunnel junction of which a plasma frequency varies depending on an intersecting angle, as a leading technology for creating a high temperature superconductive Josephson tunnel junction device capable of controlling properties.

To solve the problems aforementioned, the present invention provides a method of varying the plasma frequency of a high temperature superconductive Josephson tunnel junction as claimed in claim 1. Said junction is formed by bonding two single crystals of a high temperature superconductor on a substrate to produce a single high temperature superconductive Josephson tunnel junction in the bonded portion, wherein said plasma frequency is varied by bonding said single crystals within a range of intersecting angles of 0 to 90°.

In the invention, preferably, the two single crystals are whiskers, finely processed single crystals or thin films, or a combination of two types of them, and each single crystal of the high temperature superconductor is formed of a bismuth compound and its superconductive phase is any one of 2212 phase, 2201 phase and 2223 phase.

A high temperature superconductive Josephson tunnel junction involving the method of the invention is specifically described below with examples.

In the accompanying drawings :
Fig. 1 is a graph showing a relation of intersecting angles and plasma frequencies of high temperature superconductor single crystals with respect to a high temperature superconductive Josephson tunnel junction obtained in example 1.
Fig. 2 is a graph showing Shapiro steps observed by emission of a high frequency of 20 GHz to the high temperature superconductive Josephson tunnel junction obtained in example 1.
Fig. 3 is a graph showing a Fraunhofer pattern observed by application of a magnetic field to the high temperature superconductive Josephson tunnel junction obtained in example 1.
Fig. 4 is a graph showing a current-voltage property of face b and face c of a high temperature superconductive Josephson tunnel junction obtained in example 2.

A high temperature superconductive Josephson tunnel junction usable in the method of the present invention is, as described above, a single high temperature superconductive Josephson tunnel junction formed in a bonded portion where two single crystals of a high temperature superconductor is bonded on a substrate in a range of intersecting angles of 0 degrees to 90 degrees.

In a Josephson tunnel junction, a thin insulator layer is sandwiched between superconductors and the insulator layer is formed at an interface of two crystals. Therefore, in the high temperature superconductive Josephson tunnel junction in accordance with the invention, use of two single crystals, in one aspect, is for formation of an appropriate insulator layer at an interface. That is, a single Josephson tunnel junction is formed because the insulator layer formed at the interface of two single crystals is used. Unlike a polycrystal, a single crystal is uniform in an azimuth of a crystal. Therefore, as described below, in other aspect, the use of two single crystals is for controlling a plasma frequency fp of a high temperature Josephson tunnel junction by varying a critical electric current density based on an intersecting angle of the two single crystals.

In the high temperature superconductive Josephson tunnel junction usable in accordance with the invention, as described above, an intersecting angle of two high temperature superconductor single crystals bonded on the substrate, that is, an angle not larger of two angles formed by two intersecting bismuth high temperature superconductor single crystals, is in a range of 0 degree to 90 degrees. A plasma frequency fp of the high temperature superconductive Josephson tunnel junction which intersects and is bonded in the range varies because a critical current density Jc changes depending on an intersecting angle. In other words, in the high temperature superconductive Josephson tunnel junction usable in accordance with the invention, a plasma frequency fp varies depending on an intersecting angle and therefore the plasma frequency fp can be controlled by varying an intersecting angle of two high temperature superconductor single crystals to be bonded on the substrate.

The plasma frequency peculiar to a high temperature superconductor generally ranges from hundreds of GHz to several THz and hence a high temperature superconductive Josephson tunnel device using a high temperature superconductor can respond to higher frequencies, but could not respond to lower frequencies. However, by the high temperature superconductive Josephson tunnel junction usable in accordance with the invention, a plasma frequency fp can be changed in a range of two or three digits or more from a general plasma frequency peculiar to a high temperature superconductor to several GHz. As shown in examples, high frequency response (Shapiro steps) is observed, for example, at 20 GHz, which has been impossible to respond to. Theoretically, it is expected to respond to lower frequencies.

Generally, in a high temperature superconductive Josephson tunnel junction, as compared with a high temperature superconduction proximity effect device, IcRn (a product of a critical current density and a shunt resistance, a value representing a signal processing capacity of a Josephson junction) is large. When a high temperature superconductive Josephson tunnel junction device comprising the high temperature superconductive Josephson tunnel junction usable in the method of the invention is applied, for example, to a magnetic sensor, since a SQUID output is in proportion to the IcRn, the SQUID output increases, it is considered that the output/input ratio, that is, sensitivity is enhanced. Moreover, in a high temperature superconductive Josephson tunnel junction device, since a respondable maximum operating frequency fmax is also in proportion to the IcRn, as the IcRn increases, the fmax is considered to be higher. When a high temperature superconductive Josephson tunnel junction device comprising the high temperature superconductive Josephson tunnel junction usable in the method of the invention is applied, for example, to a high frequency receiver, a receiver enhanced in a frequency property from fp to fmax will be possible. When applied to an SFQ device, a fast device operating at switching time τ = 1/fmax is obtained and it is expected that a quantum computer using a SIS (superconductor/ insulator/ superconductor) junction may be produced.

When forming the high temperature superconductive Josephson tunnel junction usable in the method of the invention, two single crystals of a high temperature superconductor are disposed on a substrate at an intersecting angle in a range of 0 degree to 90 degrees and the two single crystals are bonded by heat treatment as is similar to the previous proposal. A condition of heat treatment is temperature ranging from 0 degree to a melting point of a high temperature superconductor and an oxygen partial pressure ranging from 0 to 100%. Bonding faces of the two high temperature superconductor single crystals are any one of face a, face b and face c, or a combination of two faces of them. The two thin high temperature superconductor single crystals are whiskers, a finely processed single crystals or thin films, or a combination of two types of them.

A high temperature superconductor used in the method of the invention is not particularly specified in a material classification and may be properly selected from various materials generally regarded as a high temperature superconductor. In the examples, described below, a bismuth high temperature superconductor is selected and a superconductive phase in this case is any one of 2212 phase, 2201 phase and 2223 phase. A high temperature superconductor may be properly adjusted in composition, by adding elements or replacing elements, as far as a superconductive property may not be spoiled.

### EXAMPLES

### (Example 1)

Two whisker single crystals of 2212 phase of bismuth high temperature superconductor were disposed on an MgO substrate by intersecting in a range of 0 degree to 90 degrees, were put in an electric furnace to heat in a condition of temperature of 850 degrees and oxygen partial pressure of 70%, and were bonded together mutually on face c.

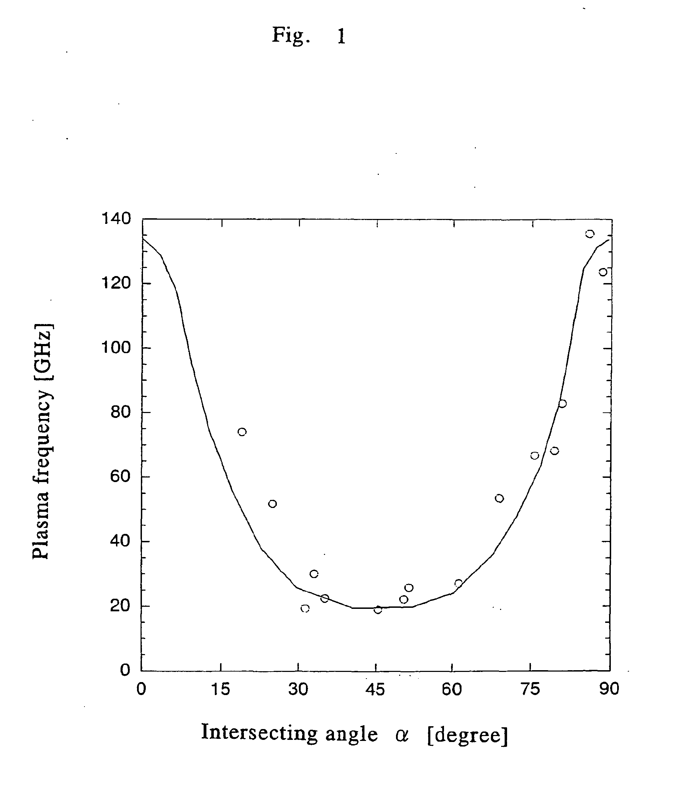

With respect to a high temperature superconductive Josephson tunnel junction thus obtained, critical current densities Jc were measured and from a change of the measured Jc, a change of plasma frequency fp of the high temperature superconductive Josephson tunnel junction depending on intersecting angles α was estimated. The result is shown in a graph in Fig. 1.

As understood from a graph in Fig. 1, the plasma frequency fp of the high temperature superconductive Josephson tunnel junction varied depending on change of an intersecting angle of two whisker single crystals. The plasma frequency fp of the high temperature superconductive Josephson tunnel junction showed high values peculiar to a high temperature superconductor at 0 degree and 90 degrees, but dropped to a bottom of about 20 GHz around 45 degrees. Depending on a heat treatment condition, a greater change of plasma frequency fp than that in the graph in Fig. 1 may be expected.

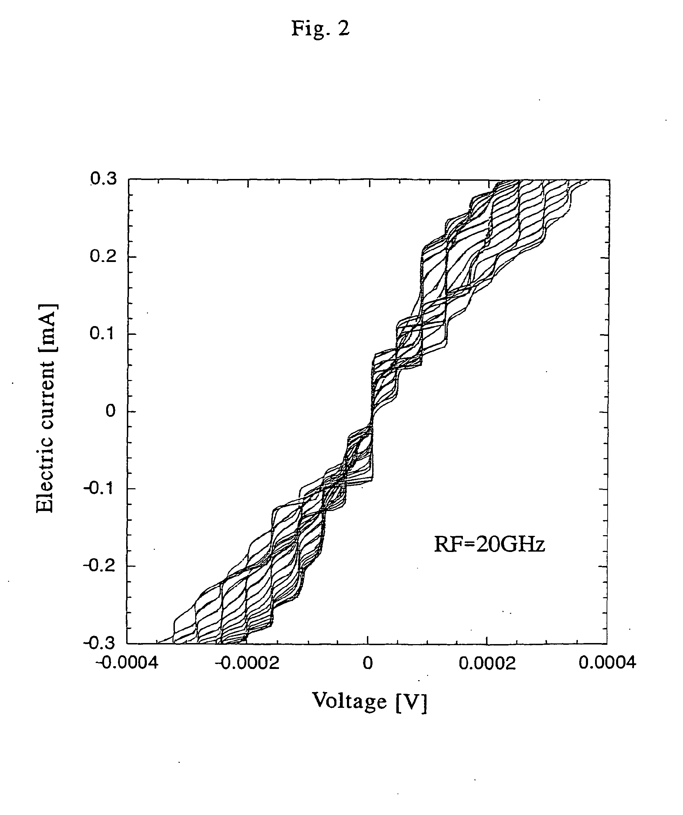

On the basis of these findings, a high frequency of 20 GHz was emitted to the high temperature superconductive Josephson tunnel junction obtained. As a result, as shown in Fig. 2, specific stair steps peculiar to high frequency response, that is, so-called Shapiro steps, were observed in a current-voltage property. It is confirmed that the high temperature superconductive Josephson tunnel junction responded to a high frequency and a function as high frequency receiving device is recognized. Steps appeared at intervals of about 40 µV and this fact tells that only one Josephson tunnel junction acted, in other words, it proves that a single Josephson tunnel junction was formed.

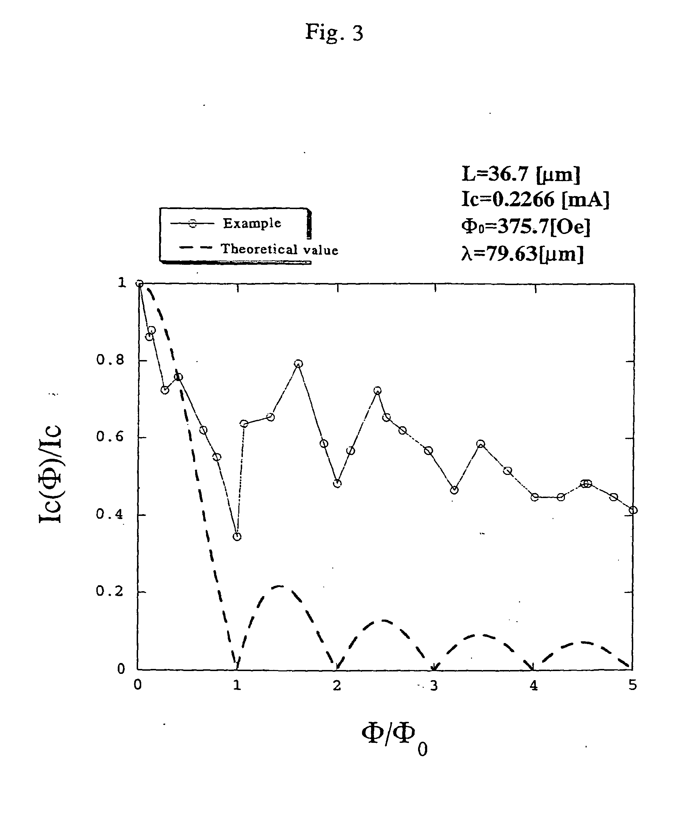

Further, with respect to the high temperature superconductive Josephson tunnel junction, changes of a critical current Ic were investigated by applying a magnetic field. The result is shown in a graph in Fig. 3. The magnetic field was applied in an in-plane direction of a sample. In the graph of Fig. 3, both axis of abscissas and axis of ordinates are standardized. For example, the axis of ordinates is standardized supposing that a critical current is 1 when a magnetic field is zero. In Fig. 3, L shows a width of a sample in a vertical direction to a magnetic field, Ic is a critical current, Φ₀ is a magnetic field when one magnetic flux is inserted to length L.

A critical current density is determined by dividing a current value before standardization by area and it is a value proportional to the axis of ordinates in the graph in Fig. 3. It is hence known from the graph in Fig. 3 that critical current densities change periodically by application of a magnetic field. This phenomenon is known as a Fraunhofer pattern and it shows that the high temperature superconductive Josephson tunnel junction responds to a magnetic field. This Fraunhofer pattern is a basic property of a SQUID magnetic sensor.

### (Example 2)

Two whisker single crystals of 2212 phase of bismuth high temperature superconductor were disposed on an MgO substrate by intersecting at an intersecting angle of 90 degrees and put in an electric furnace to heat in a condition of temperature of 850 degrees and oxygen partial pressure of 70%. Face b and face c were bonded.

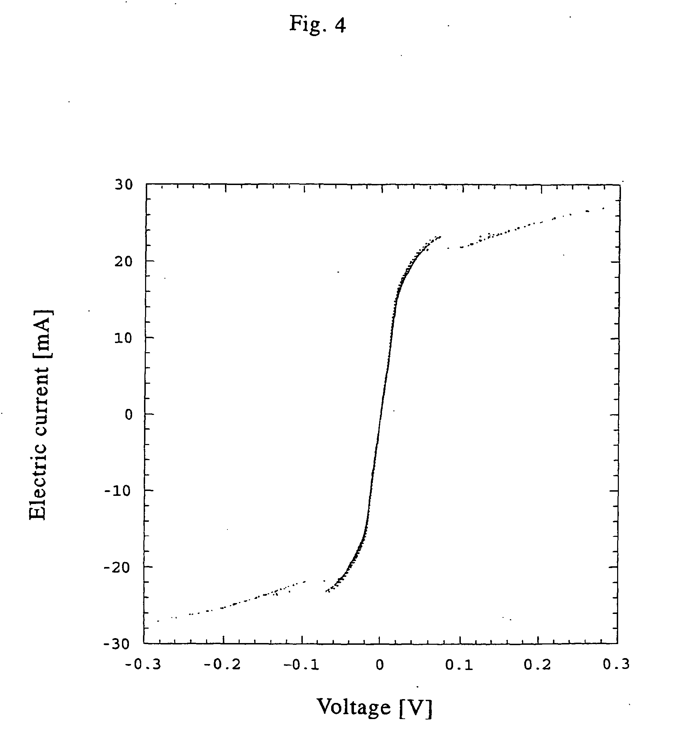

Fig. 4 is a graph showing a current-voltage property of a high temperature superconductive Josephson tunnel junction bonded between face b and face c. As recognized from the graph in Fig. 4, a single high temperature superconductive Josephson tunnel junction was obtained. That is, there is a region where no voltage generates at low currents and it means that a superconductive current is flowing in the junction. When a current flows over a critical current value, a voltage is generated suddenly. This voltage generation corresponds to a jump appearing in the graph in Fig. 4. Since only one jump is recorded, it is confirmed that a single high temperature superconductive Josephson tunnel junction is obtained. Hence, it is rationally considered that every phenomenon that is confirmed in example 1 similarly occurs in the high temperature superconductive Josephson tunnel junction bonded between face b and face c.

The present invention is not limited to the examples alone, but may be variously modified in a type of a high temperature superconductor, a shape of a single crystal, a condition of heat treatment and other details.

As described specifically above, according to the invention, a method of varying the plasma frequency of a high temperature superconductive Josephson tunnel junction is realized wherein the plasma frequency varies depending on the intersecting angle of two single crystals of a high temperature superconductor.

## Claims

1. A method of varying the plasma frequency of a high temperature superconductive Josephson tunnel junction, said junction being formed by bonding two single crystals of a high temperature superconductor having a-, b- and c-faces on a substrate to produce a single high temperature superconductive Josephson tunnel junction in the bonded portion where bonding faces of said single crystals are equal to or different from each other and the bonding face of each single crystal is selected from said a-face, b-face or c-face, wherein said plasma frequency is varied by bonding said single crystals within a range of intersecting angles of 0 to 90°.

2. A method as claimed in claim 1, wherein the two single crystals are whiskers, finely processed single crystals or thin films, or a combination of two types of them.

3. A method as claimed in claim 1 or 2, wherein each single crystal of the high temperature superconductor is formed of a bismuth compound and its superconductive phase is any one of 2212 phase, 2201 phase and 2223 phase.

## Patentansprüche

1. Verfahren zum Variieren der Plasmafrequenz eines hochtemperatur-supraleitenden Josephson-Tunnel-Übergangs, wobei der Übergang durch Kontaktieren zweier Einkristalle eines Hochtemperatur-Supraleiters mit a-, b- und c-Flächen auf einem Substrat gebildet wird, um einen einzelnen hochtemperatur-supraleitenden Josephson-Tunnelübergang in dem kontaktierten Bereich zu erzeugen, wobei die kontaktierten Flächen der Einkristalle einander gleichen oder voneinander verschieden sind und die Kontaktfläche jedes Einkristalls ausgewählt ist aus der a-Fläche, der b-Fläche oder der c-Fläche, wobei die Plasmafrequenz **dadurch** variiert wird, dass man die Einkristalle in einem Bereich von Schnittwinkeln von 0 bis 90° miteinander kontaktiert.

2. Verfahren gemäß Anspruch 1, wobei die beiden Einkristalle Whisker, feinbearbeitete Einkristalle oder dünne Schichten oder eine Kombination von zwei dieser Typen sind.

3. Verfahren gemäß Anspruch 1 oder 2, wobei jeder Einkristall des Hochtemperatur-Supraleiters aus einer Bismutverbindung besteht und seine supraleitende Phase eine 2212-Phase, 2201-Phase oder 2223-Phase ist.

## Revendications

1. Procédé de variation de la fréquence de plasma d'une jonction Josephson à effet tunnel supraconductrice à haute température, ladite jonction étant formée par liaison de deux monocristaux d'un supraconducteur à haute température ayant des faces a, b et c sur un substrat pour produire une jonction Josephson à effet tunnel supraconductrice à haute température dans la partie liée où les faces de liaison desdits monocristaux sont égales les unes aux autres ou différentes les unes des autres, et la face de liaison de chaque monocristal est choisie parmi ladite face a, ladite face b ou ladite face c, dans lequel la variation de ladite fréquence de plasma est assurée par liaison desdits monocristaux dans une plage d'angles d'intersection de 0 à 90°.

2. Procédé selon la revendication 1, dans lequel les deux monocristaux sont des trichites, des monocristaux finement traités ou des films minces ou une combinaison de deux types d'entre eux.

3. Procédé selon la revendication 1 ou 2, dans lequel chaque monocristal du supraconducteur à haute température est formé d'un composé de bismuth et sa phase supraconductrice est une phase quelconque choisie parmi une phase 2212, une phase 2201 et une phase 2223.
